# EUROPEAN PATENT SPECIFICATION

(11) **EP 4 477 898 B1**
(45) Date of publication and mention of the grant of the patent: **15.07.2026**
(21) Application number: 23787637.0
(22) Date of filing: 10.04.2023
(51) Int. Cl.: G06F 1/16, F16C 11/04, H04M 1/02

(54) **HINGE MECHANISM AND ELECTRONIC DEVICE**
SCHARNIERMECHANISMUS UND ELEKTRONISCHE VORRICHTUNG
MÉCANISME DE CHARNIÈRE ET DISPOSITIF ÉLECTRONIQUE

(30) Priority: 15.04.2022 CN 202210396961
(43) Date of publication of application: 18.12.2024
(73) Proprietor: VIVO MOBILE COMMUNICATION CO., LTD., Dongguan, Guangdong 523863 (CN)
(72) Inventor: TAN, Xiaogang, Dongguan, Guangdong 523863 (CN); HE, Zongwen, Dongguan, Guangdong 523863 (CN); LIU, Ximing, Dongguan, Guangdong 523863 (CN); CHENG, Dongcun, Dongguan, Guangdong 523863 (CN)
(74) Representative: Murgitroyd & Company
(86) International application number: PCT/CN2023/087285
(87) International publication number: WO 2023/197993

(56) References cited:
- CN-A- 111 706 604
- CN-A- 112 991 958
- CN-A- 113 163 030
- CN-A- 113 315 860
- CN-A- 113 315 860
- CN-A- 114 658 750
- CN-A- 114 658 751
- US-A1- 2021 165 466
- US-A1- 2021 165 466
- US-A1- 2024 111 340

## Description

### TECHNICAL FIELD

This application pertains to the field of communication technologies and specifically relates to a hinge mechanism and an electronic device.

### BACKGROUND

Foldable electronic devices are increasingly favored by consumers for achieving balance among characteristics of portability, large display area, and the like. Foldable electronic devices are typically provided with hinge mechanisms, and the hinge mechanisms enable the foldable electronic devices to be foldable. Currently, most foldable electronic devices adopt an outward folding structure. When such electronic device is in a folded state, its display screen is located on an outer side, which makes the display screen of the electronic device prone to friction or collision with external objects, causing serious adverse effects on the service life of the display screen.

US 2021165466A1 discloses an electronic device including a hinge assembly. The electronic device includes a first housing, a second housing, a hinge assembly coupling the first housing and the second housing so that the second housing is rotatable with respect to the first housing, and a flexible display disposed from one region of the first housing to at least one region of the second housing across the hinge assembly.

CN 113315860A discloses that: in a folding mechanism, a first housing seat is rotatably disposed on a first screen support plate, a second housing seat is rotatably disposed on a second screen support plate. and a third screen support plate is movably connected to a base in a support direction of the third screen support plate; the first housing seat is rotatably connected to the base via a first swing arm, the second housing seat is rotatably connected to the base via a second swing arm, the first screen support plate is slidably and rotatably connected to the base via a third swing arm, the second screen support plate is slidably and rotatably connected to the base via a fourth swing arm, a rotation axis of the first swing arm is spaced apart from that of the third swing arm.

### SUMMARY

Embodiments of this application are intended to provide a hinge mechanism and an electronic device, so as to solve the problem that currently, when an electronic device is in a folded state, its display screen is prone to friction or collision with external objects, causing serious adverse effects on the service life of the display screen.

According to a first aspect, an embodiment of this application provides a hinge mechanism, which is defined in claim 1.

According to a second aspect, an embodiment of this application provides an electronic device, which is defined in claim 8.

Further advantageous embodiments of the present disclosure are indicated in the dependent claims.

It is to be understood that both the foregoing general description and the following detailed description are exemplary only, and are not restrictive of the present disclosure.

### BRIEF DESCRIPTION OF DRAWINGS

The accompanying drawings described herein are intended for a further understanding of this application and constitute a part of this application. Illustrative embodiments of this application and descriptions thereof are intended to explain this application, and do not constitute any inappropriate limitation on this application. In the accompanying drawings:
FIG. 1 is a schematic exploded view of a hinge mechanism disclosed in an embodiment of this application;
FIG. 2 is a schematic exploded view of a partial structure of a hinge mechanism disclosed in an embodiment of this application;
FIG. 3 is a schematic diagram of a partial structure of a base in a hinge mechanism disclosed in an embodiment of this application;
FIG. 4 is a schematic structural diagram of a linkage member disclosed in an embodiment of this application;
FIG. 5 is a schematic diagram of a partial structure of a hinge mechanism disclosed in an embodiment of this application; and
FIG. 6 is a schematic assembly diagram of a support plate and a base in a hinge mechanism disclosed in an embodiment of this application.

### Description of reference signs:

100. base; 110. fixing part; 120. base body; 131. first rotating part; 132. guide rail; 140. limiting member; 150. positioning member; 161. first limiting protrusion; 171. first hinging part; 181. gear hole; 190. limiting slot;
200. linkage member; 210. connecting part; 220. second rotating part; 221. guide slot; 231. second hinging part; 241. sliding sleeve;
300. floating support part;
410. first synchronization swing arm; 420. second synchronization swing arm; 431. first gear; 432. second gear; 441. second limiting protrusion; 450. gear shaft;
510. first elastic member; 520. second elastic member; 530. first screw; 540. second screw;
610. support plate; 620. third hinging part; 630. fourth hinging part;
710. pin shaft; and 720. connecting rod.

### DESCRIPTION OF EMBODIMENTS

The following clearly describes the technical solutions in the embodiments of this application with reference to the accompanying drawings in the embodiments of this application. Apparently, the described embodiments are only some rather than all of the embodiments of this application. All other embodiments obtained by persons of ordinary skill in the art based on the embodiments of this application without creative efforts fall within the protection scope of this application.

The terms "first", "second", and the like in the specification and claims of this application are used to distinguish between similar objects rather than to describe a specific order or sequence. It should be understood that data used in this way are interchangeable in appropriate circumstances such that the embodiments of this application can be implemented in an order other than those illustrated or described herein. In addition, "first" and "second" are typically used to distinguish objects of a same type and do not limit quantities of the objects. For example, there may be one or more first objects. In addition, "and/or" in the specification and claims represents at least one of the connected objects, and the character "/" generally indicates that the contextually associated objects have an "or" relationship.

The following describes in detail a hinge mechanism and an electronic device provided in the embodiments of this application through specific embodiments and application scenarios thereof with reference to the accompanying drawings.

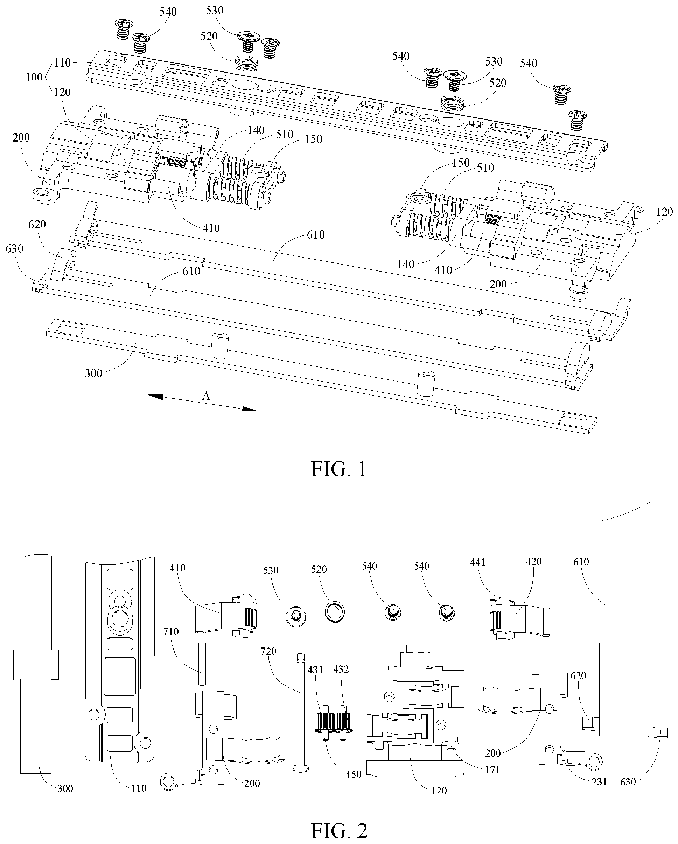

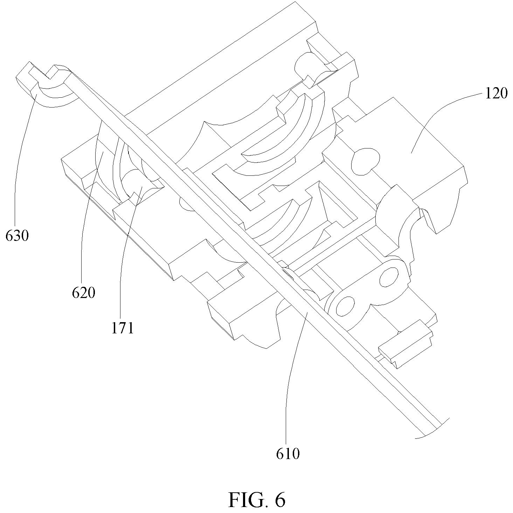

As shown in FIGs. 1 to 6, an embodiment of this application discloses a hinge mechanism. The hinge mechanism can be applied to an electronic device to enable the electronic device to be foldable. The electronic device typically includes a display screen and screen support parts, where the screen support part is configured to provide an installation foundation for the display screen and can support the display screen. The screen support part is provided in plurality and may be specifically provided in two, three, or more. For ease of understanding, the following describes a specific structure, an operating state, and the like of the electronic device by using an example in which the electronic device includes two screen support parts. For an embodiment in which more screen support parts are provided, persons skilled in the art can make corresponding expansion based on the technical ideas of in this application. Details are not described herein again.

The two screen support parts are connected to each other through the hinge mechanism. Under the action of the hinge mechanism, the two screen support parts can move relative to each other, thereby allowing the electronic device to switch between a folded state and an unfolded state.

In a case that the electronic device is in the folded state, the two screen support parts are stacked and opposite each other, and the display screen is located between the two screen support parts. Certainly, the two screen support parts may alternatively be parallel to each other, or a relatively small acute angle may be present between the two screen support parts.

In a case that the electronic device is in the unfolded state, a surface of the display screen is a plane, and the two screen support parts are also substantially coplanar. Certainly, with consideration of the influence of factors such as machining accuracy and the property of the display screen itself, the display surface of the display screen in the unfolded state may not be an absolutely planar structure, and some positions of the display screen surface of the display may have slight bending deformation. In this case, it can also be considered that the display screen (or the electronic device) is in the unfolded state.

As described above, during the use of the electronic device, the display screen will undergo deformation with the relative movement of the screen support parts, and thus, at least a part of the display screen is a flexible structure. Specifically, the display screen may include a first display part, a second display part, and a third display part, where the first display part and the second display part are connected to each other through the third display part, so that the three parts are connected as a whole. Optionally, the first display part and the second display part are hard screens for improving their service life. The third display part is a flexible screen, and the position of the third display part corresponds to the position of the hinge mechanism, so as to ensure that the third display part will not hinder the normal bending and unfolding actions of the hinge mechanism. In another embodiment of the application, the display screen may alternatively be a flexible screen as a whole, which can also ensure that the display screen can deform with the action of the hinge mechanism, and can improve the consistency of the display screen, thereby improving the display effect of the display screen.

As shown in FIGs. 1 to 6, the hinge mechanism disclosed in this embodiment of this application includes a base 100, a first rotating part 131, a linkage member 200, and a floating support part 300.

The base 100 may be made of a hard material such as metal or plastic. The base 100 is a foundational part of the entire hinge mechanism, and other structures in the hinge mechanism may be directly or indirectly installed on the base 100 so as to be connected to the base 100. Optionally, as shown in FIG. 1, the base 100 may include a fixing part 110 and a base body 120 detachably and fixedly connected to each other. The fixing part 110 may serve as a sealing structure of the base body 120, making an external structure of the entire hinge mechanism more complete and flat. The base body 120 may serve as a main part of the base 100 connected to other components. Certainly, other components may also be installed on the fixing part 110, for example, a second elastic member 520 mentioned below may be installed on the fixing part 110. As shown in FIG. 1, the fixing part 110 and the base body 120 may be detachably and fixedly connected to each other through second screws 540. Respective actual structures, sizes, and other parameters of the fixing part 110 and base body 120 may be determined based on specific situations. This is not limited herein.

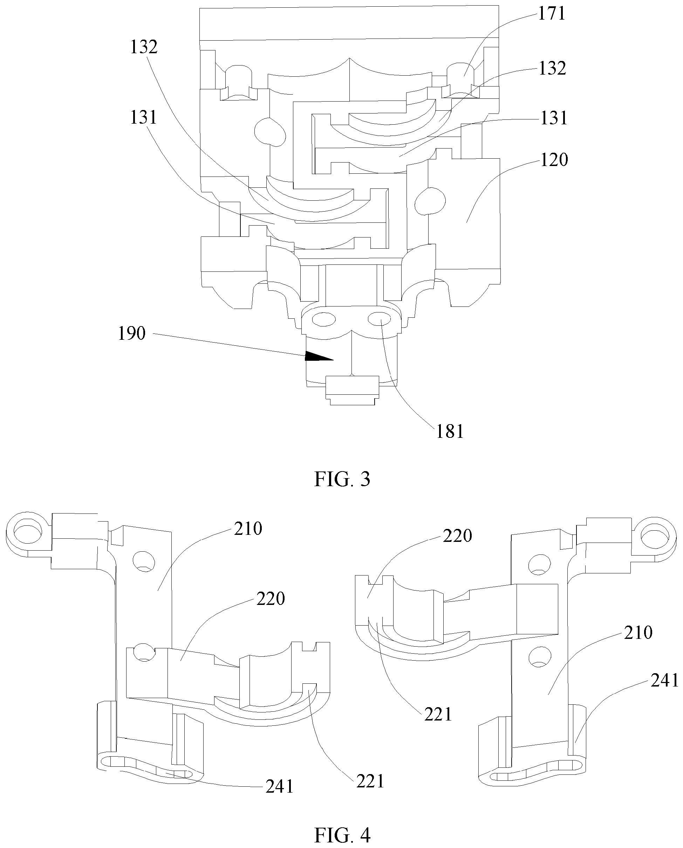

Moreover, most components or structures in the hinge mechanism are symmetrically arranged, such as the first rotating part 131. The first rotating part 131 is provided in plurality, and the plurality of first rotating parts 131 are all disposed on the base 100. After exclusion of the influence of factors such as the position, as shown in FIG. 3, the plurality of first rotating parts 131 include two first rotating parts 131 that are symmetrical in structure. One of the two first rotating parts 131 is configured to be connected to one linkage member 200, and the other is configured to be connected to another linkage member 200.

Similarly, a second rotating part 220 configured to be connected to the first rotating part 131 is also provided in plurality, and the plurality of second rotating parts 220 fit with the plurality of first rotating parts 131 in one-to-one correspondence. In the plurality of second rotating parts 220, two second rotating parts 220 fit in one-to-one correspondence with the two first rotating parts 131 that are symmetrical in structure, and are rotatably connected to the two first rotating parts 131. In addition, one of the two second rotating parts 220 is connected to a connecting part 210 of one linkage member 200, and the other is connected to a connecting part 210 of another linkage member 200.

As described above, the first rotating part 131 and the second rotating part 220 fit with each other, and the two rotatably fit with each other. Specifically, the two may each be a structure combination such as an arc-shaped structural member, with a rotating axis located outside. This can reduce the sizes of the base 100 and entire hinge mechanism and reduce the complexity of the base 100. In a case that the first rotating part 131 and the second rotating part 220 adopt the foregoing structure, a limiting structure and the like may be provided on the base 100 to limit the second rotating part 220 in a direction perpendicular to the above rotating axis, ensuring relatively stable rotatable fit between the second rotating part 220 and the first rotating part 131.

Specifically, as shown in FIGs. 3 and 4, the first rotating part 131 may be provided with a recess, and the second rotating part 220 is slidably disposed in the recess, so that the first rotating part 131 and the second rotating part 220 rotatably fit with each other. In addition, an inner wall of the recess may be provided with a guide rail 132, and an extension direction of the guide rail 132 is the same as a movement trajectory of the second rotating part 220 relative to the base 100; and the second rotating part 220 is provided with a guide slot 221. The guide rail 132 and the guide slot 221 slidably fit with each other to ensure that the first rotating part 131 and the second rotating part 220 can stably maintain a relative rotating state. Moreover, under the actions of the guide rail 132 and the guide slot 221, the first rotating part 131 and the second rotating part 220 can further have a more stable fit with each other in a limiting manner in a direction of a rotating axis of the first rotating part 131.

Furthermore, the guide rail 132 may be disposed on a side wall of the recess of the first rotating part 131, that is, a surface of the recess of the first rotating part 131 perpendicular to the rotating axis of the first rotating part 131. Based on this, the guide rail 132 and the guide slot 221 can further fit with each other in a limiting manner in a direction perpendicular to the rotating axis of the first rotating part 131, thereby ensuring high stability of rotatable fit between the first rotating part 131 and the second rotating part 220.

As described above, the hinge mechanism disclosed in this embodiment of this application includes the linkage member 200, where the linkage member 200 is provided in plurality, and each linkage member 200 includes a connecting part 210 and the foregoing second rotating part 220, so that the second rotating parts 220 of the plurality of linkage members 200 can fit with the plurality of first rotating parts 131 in one-to-one correspondence. Moreover, the linkage member 200 is an integral structural member, which can improve the reliability of connection between the second rotating part 220 and the connecting part 210, and also reduce the difficulty in assembling the second rotating part and the connecting part 210 with other components in the hinge mechanism.

As described above, at least one of the plurality of first rotating parts 131 is connected to one linkage member 200, with a linkage relationship formed between the two. At least another of the plurality of first rotating parts 131 is connected to another linkage member 200, with a linkage relationship formed between the two.

In addition, the connecting parts 210 are all configured to be fixedly connected to screen support parts of an electronic device, so that adjacent screen support parts in the electronic device can be connected to the hinge mechanism, thereby allowing adjacent screen support parts to move relative to each other through the hinge mechanism. Specifically, the connecting parts 210 may all be fixedly connected to the corresponding screen support parts through threaded components and the like. Actual structures, sizes, and the like of the connecting parts 210 may all be correspondingly determined based on actual shapes and sizes of other components such as the screen support parts in the electronic device. This is not limited herein.

As described above, at least one of the plurality of linkage members 200 is connected to at least one first rotating part 131, and at least another of the plurality of linkage members 200 is connected to at least another first rotating part 131. For ease of description, optionally, two of the plurality of linkage members 200 are a first linkage member and a second linkage member respectively, and structures, sizes, and the like of the two linkage members may be completely the same.

The first linkage member and the second linkage member may both be provided in one, and the two linkage members are respectively located on two sides of the entire hinge mechanism facing away from each other to be respectively connected to the corresponding screen support parts. In another embodiment of this application, the first linkage member and the second linkage member may both be provided in plurality. The plurality of first linkage members are all distributed on one side of the entire hinge mechanism, and the plurality of first linkage members are distributed along a direction with a larger size in the entire hinge mechanism, where the direction may specifically be a length direction of the hinge mechanism, that is, the direction of the rotating axis of the first rotating part 131 (or a first synchronization swing arm 410 mentioned below) in the hinge mechanism, and the direction is specifically direction A in FIG. 1. Correspondingly, the plurality of second linkage members are all distributed on another side of the entire hinge mechanism, and the plurality of second linkage members are distributed along the length direction of the entire hinge mechanism. The plurality of first linkage members and the plurality of second linkage members are all fixedly connected to the corresponding screen support parts of the electronic device, thereby improving the reliability of connection and stability under stress between adjacent screen support parts.

In addition, the first rotating part 131 and the second rotating part 220 rotatably fitting with each other are used, so that the base 100 can connect two adjacent screen support parts together and drive the corresponding second rotating part 220 to rotate relative to the first rotating part 131 when the first linkage member and the second linkage member move relative to each other.

As described above, the hinge mechanism includes the floating support part 300, where the floating support part 300 is disposed on a side of the base 100 facing a screen support side, that is, the floating support part 300 is located on a side of the base 100. As described above, the base 100 is a foundational part of the hinge mechanism and is substantially located at a middle position of the hinge mechanism, thereby allowing the base 100 to support the display screen and allowing the display screen to be directly or indirectly supported by the base 100. The floating support part 300 is located on the screen support side of the base 100, so that the floating support part 300 can be further used to support the display screen, thereby improving the support effect on the screen.

Moreover, the floating support part 300 and the base 100 are movably connected to each other along distribution directions of the two, so that the floating support part 300 can move in a direction approaching the base 100 or leaving the base 100. The distribution direction may specifically be a direction perpendicular to the entire hinge mechanism when the hinge mechanism is in a first state or a direction perpendicular to the display surface of the display screen in an unfolded state. More intuitively, the direction may be an exploded direction of components in FIG. 1.

During operation, the hinge mechanism with the above structure has at least two states: a first state and a second state. The first state corresponds to the foregoing unfolded state of the electronic device, and the second state corresponds to the foregoing folded state of the electronic device.

In a case that the hinge mechanism is in the first state, the connecting part 210 of the first linkage member is located on one side of the base 100, and the connecting part 210 of the second linkage member is located on another side of the base 100, so that the entire hinge mechanism is in the unfolded state to support a middle portion of the display screen, while ensuring that screen support parts connected to each other through the hinge mechanism are also substantially coplanar and respectively support two sides of the display screen.

Moreover, in the case that the hinge mechanism is in the first state, at least one of the plurality of second rotating parts 220 supports the floating support part 300, so that the hinge mechanism can enable the display screen to be stably supported by the floating support part 300 when the electronic device is in the unfolded state, improving the support effect of the hinge mechanism on the display screen. In addition, in a case that the second rotating part 220 supports the floating support part 300, a distance between the floating support part 300 and the base 100 is relatively large, to be specific, a distance between an outer side wall of the base 100 facing away from the rotating axis of the first rotating part 131 and the floating support part 300 is a first distance.

In a case that the hinge mechanism is in the second state, the connecting parts 210 of the first linkage member and second linkage member are both located on the side of the base 100 facing the screen support side. Moreover, in the case that the hinge mechanism is in the second state, the second rotating part 220 avoids the floating support part 300, so that the floating support part 300 can move in a direction approaching the base 100 under the squeezing actions of components such as the display screen. This allows the floating support part 300 to avoid the display screen, providing an avoidance space for the display screen, and preventing the display screen from being squeezed and damaged when the display screen is being folded. In addition, a distance between the floating support part 300 and the base 100 is reduced, so that a distance between the outer side wall of the base 100 and the floating support part 300 is a second distance, and the second distance is less than the first distance.

As described above, in the case that the hinge mechanism is in the second state, the connecting parts 210 of the first linkage member and second linkage member connected to the screen support parts are both located on the screen support side of the base 100, that is, the display screen and the screen support parts are all located on a same side of the base 100, so that the entire display screen is wrapped by the screen support parts and the hinge mechanism to form an "inward folded" electronic device.

An embodiment of this application discloses a hinge mechanism. Connecting parts 210 of a first linkage member and second linkage member of the hinge mechanism can be all fixedly connected to corresponding screen support parts of an electronic device, so that adjacent screen support parts can be connected to each other through the hinge mechanism. Moreover, the first linkage member can rotatably fit with a first rotating part 131 of a base 100 through a second rotating part 220, and the second linkage member rotatably fits with another first rotating part 131 of the base 100 through a second rotating part 220, so that when adjacent screen support parts move relative to each other, the first linkage member and the second linkage member can also move relative to each other, allowing the electronic device to be unfolded and folded. In addition, the electronic device formed using the hinge mechanism is an inward folded electronic device, so that in a case that the electronic device is in a folded state, the screen support parts and the hinge mechanism can protect a display screen and prevent the display screen from experiencing friction or collision with external objects. This can prolong the service life of the display screen in the electronic device.

Furthermore, in the hinge mechanism, the linkage member 200 is an integral structural member, which allows for relatively high reliability of connection between the connecting part 210 and the second rotating part 220, and can reduce the assembly difficulty of the connecting part 210 and the second rotating part 220 in a process of assembling the base 100, reducing connection materials.

To allow the first linkage member and the second linkage member to rotate synchronously relative to the base 100, optionally, as shown in FIG. 2, the hinge mechanism disclosed in this embodiment of this application may further include a synchronization component, where the synchronization component includes a first synchronization swing arm 410 and a second synchronization swing arm 420. The first synchronization swing arm 410 is connected to the first linkage member, with a linkage relationship formed between the two, so that the first linkage member can drive the first synchronization swing arm 410 to rotate relative to the base 100. The second synchronization swing arm 420 is connected to the second linkage member, with a linkage relationship formed between the two, so that the second linkage member can drive the second synchronization swing arm 420 to rotate relative to the base 100. In this way, when the first linkage member and the second linkage member move relative to each other, the first synchronization swing arm 410 and the second synchronization swing arm 420 can also be driven to rotate relative to each other. Moreover, the first synchronization swing arm 410 and the second synchronization swing arm 420 are in transmission connection with each other, so that when an acting force is applied to only one of the first linkage member and the second linkage member, both the first linkage member and the second linkage member can also rotate synchronously relative to the base 100 under transmission actions of the first synchronization swing arm 410 and the second synchronization swing arm 420.

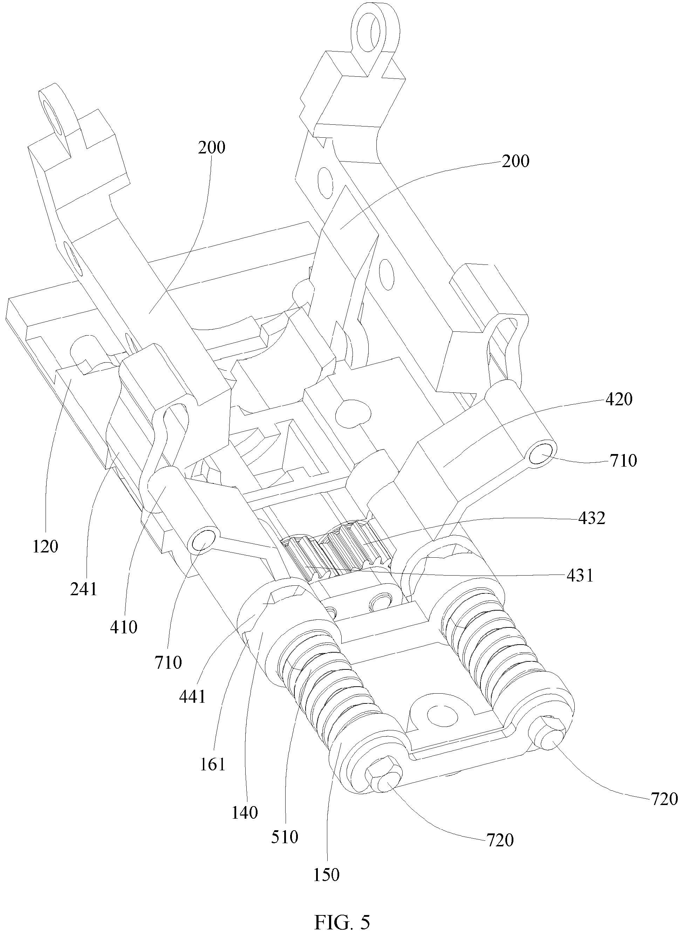

Specifically, the first synchronization swing arm 410 and the second synchronization swing arm 420 may be in transmission connection with each other through engaging teeth, or the two may be in transmission connection with each other through other transmission members. Moreover, to ensure that the first synchronization swing arm 410 and the second synchronization swing arm 420 can be in stable transmission fit with each other, as shown in FIG. 5, the first synchronization swing arm 410 and the second synchronization swing arm 420 may each rotatably fit with the base 100 through a connecting rod 720, thereby ensuring that the first synchronization swing arm 410 can stably drive the second synchronization swing arm 420 to rotate relative to the base 100 in a case that the first synchronization swing arm 410 rotates relative to the base 100. Specifically, the first synchronization swing arm 410 and the second synchronization swing arm 420 may be each in stable rotatable fit with the base 100 through the connecting rod 720, and the two connecting rods 720 are apart from each other in a direction perpendicular to the rotating axis. In a circumferential direction of the rotating axis of the first rotating part 131, the first synchronization swing arm 410 and the second synchronization swing arm 420 may each rotatably fit with the corresponding connecting rod 720, or the connecting rods 720 may both rotatably fit with the base 100.

As described above, the first synchronization swing arm 410 and the second synchronization swing arm 420 may be in transmission connection with each other through engaging teeth, that is, the first synchronization swing arm 410 and the second synchronization swing arm 420 are each provided with engaging teeth, and the two may be directly engaged through their respective engaging teeth to form a transmission fit relationship.

To reduce pitch circle diameters of the engaging teeth of the first synchronization swing arm 410 and second synchronization swing arm 420, in another embodiment of this application, as shown in FIGs. 2 and 5, the hinge mechanism may further include a first gear 431 and a second gear 432 engaged with each other, so that the first gear 431 and the second gear 432 can be used to provide a bridging effect for the transmission connection between the first synchronization swing arm 410 and the second synchronization swing arm 420, reducing the pitch circle diameters of the engaging teeth of the first synchronization swing arm 410 and second synchronization swing arm 420, thereby reducing structural sizes of corresponding portions of the first synchronization swing arm 410 and second synchronization swing arm 420, and reducing the size of the hinge mechanism in the direction of the rotating axis of the first rotating part 131.

Certainly, to ensure stability of movement of the first gear 431 and the second gear 432, the first gear 431 and the second gear 432 may be each provided with a gear shaft 450, and the gear shafts 450 are installed in gear holes 181 of the base 100, to support the first gear 431 and the second gear 432. Correspondingly, one of the first gear 431 and the base 100 needs to rotatably fit with the gear shaft 450, and the gear shaft 450 corresponding to the second gear 432 also needs to rotatably fit with the base 100 or the second gear 432.

In this embodiment, peripheral walls of the first synchronization swing arm 410 and the second synchronization swing arm 420 can be processed to form the engaging teeth. In another embodiment of this application, a matching gear may further be installed on the connecting rod 720, and the matching gear and the first synchronization swing arm 410 are fixed relative to each other in the circumferential direction of the rotating axis, so as to drive the matching gear to rotate during rotation of the first synchronization swing arm 410. The matching gear being in transmission connection with the first gear 431 can also allow the first synchronization swing arm 410 to be in transmission connection with the first gear 431.

With this technical solution adopted, gear standard parts can be directly used as the engaging teeth of the first synchronization swing arm 410, so that there is no need to additionally process the engaging teeth on the peripheral wall of the first synchronization swing arm 410, and the overall processing difficulty of the hinge mechanism can be greatly reduced. Similarly, the second synchronization swing arm 420 may also be provided with a matching gear, and the matching gear is engaged with the second gear 432, so that the second synchronization swing arm 420 can also be in transmission connection with the second gear 432 through the matching gear.

In the foregoing embodiment, the first synchronization swing arm 410 and the corresponding matching gear are used as an example, where the two may be fixed relative to each other by welding in the circumferential direction of the rotating axis. With consideration of later maintenance of the hinge mechanism, the first synchronization swing arm 410 and the corresponding connecting rod 720 may be fixed relative to each other in the circumferential direction of the rotating axis of the first rotating part 131, and the matching gear and the connecting rod 720 are also fixed relative to each other in the above direction. In this case, it can be ensured that the first synchronization swing arm 410 and the matching gear can be fixed relative to each other through the connecting rod 720 in the above circumferential direction. Similarly, the second synchronization swing arm 420 and the corresponding matching gear can also be fixed relative to each other in the above circumferential direction through the foregoing technical solution.

In the foregoing embodiment, the connecting rod 720 and the first synchronization swing arm 410 may fit with each other through key connection, thereby allowing the connecting rod 720 to rotate with the first synchronization swing arm 410 relative to the base 100. In a process of assembling the connecting rod 720 and the base 100, a limiting structure may be provided on the base 100, and the first gear 431 and the second gear 432 can be limited within the limiting structure, so that the first gear 431 and the second gear 432 are each relatively stably fixed relative to the base 100 in the direction of the rotating axis.

As described above, the first synchronization swing arm 410 and the second synchronization swing arm 420 may be each provided with the matching gear, and the first gear 431 and the second gear 432 are each in transmission fit with the matching gear. Specifically, the matching gear disposed at an end of the connecting rod 720 fitting with the first synchronization swing arm 410 may specifically be a third gear, and the matching gear disposed at an end of the connecting rod 720 fitting with the second synchronization swing arm 420 may specifically be a fourth gear. With consideration that the first synchronization swing arm 410 and the second synchronization swing arm 420 are substantially symmetrical in structure, the following uses the first synchronization swing arm 410 for description. Through key connection, the third gear, the connecting rod 720, and the first synchronization swing arm 410 can be fixed relative to each other in the circumferential direction of the rotating axis, ensuring that the third gear and the first synchronization swing arm 410 can rotate synchronously.

Furthermore, the base 100 may be provided with a limiting structure, where the limiting structure may specifically include a limiting slot 190, so that in a process of assembling the first gear 431, the second gear 432, and the base 100, the first gear 431 and the second gear 432 can be both installed in the limiting slot 190, and the limiting slot 190 can limit the first gear 431 and the second gear 432. In addition, a gear hole 181 may be processed and formed in a side wall of the limiting slot 190, and an end of the gear shaft 450 is inserted through the first gear 431 (or the second gear 432) through the gear hole 181 and is ultimately inserted into another side wall of the limiting slot 190 to support the first gear 431.

In another embodiment of this application, as shown in FIG. 2, the first gear 431 and the gear shaft 450 form an integral structural member. In this case, the reliability of connection between the first gear 431 and the gear shaft 450 can be improved, thereby ensuring the stability of linkage between the first gear 431 and the first synchronization swing arm 410. In this embodiment, the size of the limiting slot 190 can be designed such that the limiting slot 190 can limit the first gear 431 without limiting the gear shaft 450.

As described above, the first synchronization swing arm 410 and the second synchronization swing arm 420 are connected to the first linkage member and the second linkage member respectively. Since the first synchronization swing arm 410 and the corresponding first rotating part 131 have different rotating axes, the first synchronization swing arm 410 moves relative to the first linkage member during rotating along with the first linkage member along the axis of the first rotating part 131. In view of this, the first synchronization swing arm 410 may slidably fit with the first linkage member. As shown in FIG. 5, the first synchronization swing arm 410 may be slidably connected to the first linkage member through a sliding sleeve 241 and a pin shaft 710 that slidably fit with each other. The sliding sleeve 241 is provided with a rail. The pin shaft 710 is inserted through the sliding sleeve 241 and moves along the rail relative to the sliding sleeve 241.

To prevent the adverse effects on transmission connection between the first synchronization swing arm 410 and the first gear 431 (or the second synchronization swing arm 420) caused by relative movement between the first synchronization swing arm 410 and the connecting rod 720 in the direction of the rotating axis, optionally, the hinge mechanism disclosed in this embodiment of this application may further include a first elastic member 510. In the direction of the rotating axis of the first rotating part 131, the first elastic member 510 is connected between the base 100 and the first synchronization swing arm 410, so that the first elastic member 510 is used to allow the first synchronization swing arm 410 and the base 100 to be in squeezing fit with each other in the direction of the rotating axis of the first rotating part 131, thereby limiting the autonomous rotation of the first synchronization swing arm 410 and allowing the hinge mechanism to have a damping effect. In addition, under the action of the first elastic member 510, the first synchronization swing arm 410 can be further prevented from moving relative to the base 100 along the direction of the foregoing rotating axis.

Specifically, the first elastic member 510 and the first synchronization swing arm 410 may be directly connected to each other through abutting or fixed connection, or the two may alternatively be indirectly connected together through other structural members, so that an elastic force of the first elastic member 510 can act on the first synchronization swing arm 410. The first elastic member 510 is in a squeezed state or a stretched state at all times, so that the hinge mechanism, in any unfolding angle, can enable the first synchronization swing arm 410 to be squeezed onto the base 100, thereby allowing the first synchronization swing arm 410 to have a damping effect at all times. Alternatively, another structural member may be further additionally provided, and the first synchronization swing arm 410 and the base 100 are squeezed against each other only when the hinge mechanism is within some angle ranges, while the first synchronization swing arm 410 and the base 100 may be substantially not squeezed against each other when the hinge mechanism is within other angle ranges.

More specifically, the first elastic member 510 is in a stretched or compressed state to squeeze the first synchronization swing arm 410 and a surface of the base 100 attached to the first synchronization swing arm 410. In this embodiment, the base 100 may be provided with a notch, and the first synchronization swing arm 410 and the first elastic member 510 are both disposed within the notch, so that a first side wall of the notch of the base 100 facing the first synchronization swing arm 410 is attached to the first synchronization swing arm 410. In addition, two ends of the first elastic member 510 respectively abut against the first synchronization swing arm 410 and a second side wall of the notch of the base 100, and the second side wall and the first side wall are disposed opposite each other in the direction of the rotating axis. Certainly, there are also a variety of combinations for arrangement positions and connection manners of the first elastic member 510. Details are not described herein.

In another embodiment of this application, as shown in FIG. 5, the hinge mechanism includes a first elastic member 510, a limiting member 140, and a positioning member 150. The positioning member 150 may specifically be a flat plate-shaped structural member, and the positioning member 150 and the base 100 are apart from each other and fixedly disposed in the direction of the rotating axis. The positioning member 150 and the base 100 may be integrally formed to improve the stability of connection therebetween. Specifically, the base 100 may be provided with an open slot, and the positioning member 150 is disposed opposite an opening of the open slot. Based on this, the first elastic member 510 and the first synchronization swing arm 410 may be both disposed between the open slot of the base 100 and the positioning member 150. The limiting member 140 may be disposed between the first synchronization swing arm 410 and the positioning member 150.

Moreover, as shown in FIG. 5, an end of the limiting member 140 facing the first synchronization swing arm 410 is provided with a plurality of first limiting protrusions 161 spaced apart along the circumferential direction of the rotating axis (that is, a direction around the rotating axis). Correspondingly, an end of the first synchronization swing arm 410 facing the limiting member 140 is provided with a plurality of second limiting protrusions 441 spaced apart along the circumferential direction of the rotating axis.

Any one of the plurality of first limiting protrusions 161 may be clamped in a gap between any two adjacent ones of the plurality of second limiting protrusions 441, and any one of the plurality of second limiting protrusions 441 may be clamped in a gap between any two adjacent ones of the plurality of first limiting protrusions 161, so that during the relative rotation of the first synchronization swing arm 410 and the limiting member 140 along the circumferential direction of the rotating axis, through the first limiting protrusions 161 and the second limiting protrusions 441, not only the limiting member 140 and the first synchronization swing arm 410 can rotatably fit with each other in the circumferential direction of the rotating axis, but also the limiting member 140 and the first synchronization swing arm 410 can movably fit with each other in the direction of the rotating axis, where the movably fit specifically refers to reciprocating movement along the direction of the rotating axis.

In the foregoing embodiment, one of the limiting member 140 and the first synchronization swing arm 410 may be connected to one end of the first elastic member 510, and one of the base 100 and the positioning member 150 may be connected to the other end of the first elastic member 510. The compressed or stretched state of the first elastic member 510 is correspondingly set based on specific situations of components connected to the first elastic member 510, that is, the limiting member 140 and the first synchronization swing arm 410 can be in a squeezed state in the direction of the rotating axis of the first rotating part 131. As described above, in a case that the limiting member 140 is located between the first synchronization swing arm 410 and the positioning member 150, two ends of the first elastic member 510 facing away from each other can abut against the limiting member 140 and the positioning member 150 respectively.

More specifically, in a fitting state in which the first limiting protrusion 161 is located between two adjacent second limiting protrusions 441 and two sides of the first limiting protrusion 161 facing away from each other are in contact with two second limiting protrusions 441 on the two sides of the first limiting protrusion 161 facing away from each other, the first elastic member 510 can be in a natural state. In addition, in other states than the fitting state, the first elastic member 510 can be in the stretched or squeezed state, thereby ensuring that the first elastic member 510 tends to make the first limiting protrusion 161 and the second limiting protrusion 441 be in the above fitting state and tends to switch to the above fitting state.

With the foregoing technical solution adopted, if the first synchronization swing arm 410 and the limiting member 140 are subjected to no external force, the hinge mechanism can stably be in a state of at least one specified angle. Certainly, during the design of specific structures of the first limiting protrusion 161 and the second limiting protrusion 441, when it is also necessary to ensure that the hinge mechanism is in the unfolded state or the folded state, the first limiting protrusion 161 and the second limiting protrusion 441 can be in the above fitting state, so that the hinge mechanism can stably hover at the unfolded state, the folded state, or at least another angle between the two states, thereby expanding application scenarios of the electronic device and improving the user experience.

As described above, in the case that the hinge mechanism is in the second state, the connecting parts 210 of the first linkage member and second linkage member are both located on the side of the base 100 facing the screen support side, that is, the hinge mechanism is applicable to an inward folded electronic device. When such electronic device is in a folded state, the hinge mechanism needs to be used for providing an accommodating space for a display screen, ensuring that the display screen is not squeezed by components moving relative to each other in the hinge mechanism.

In addition, in the foregoing embodiment, the floating support part 300 capable of moving relative to the base 100 may be provided to provide avoidance for the display screen. More specifically, in a case that the hinge mechanism is provided with the floating support part 300, as shown in FIGs. 1 and 2, the floating support part 300 may be provided with a second elastic member 520, that is, the hinge mechanism disclosed in this embodiment of this application may further include a second elastic member 520, where the second elastic member 520 may be connected between the floating support part 300 and the base 100. Moreover, in the case that the hinge mechanism is in the first state, at least one of the plurality of second rotating parts 220 squeezes or stretches the second elastic member 520 while supporting the floating support part 300, so as to squeeze the floating support part 300 and the second rotating part 220. Specifically, as shown in FIG. 3, the second elastic member 520 may be assembled between the floating support part 300 and the base 100 via components such as a first screw 530, and the second elastic member 520 is squeezed between the first screw 530 and the base 100.

Furthermore, in the case that the hinge mechanism is in the second state, since the second rotating part 220 avoids the floating support part 300, the floating support part 300 can reset under an elastic action of the second elastic member 520, that is, the floating support part 300 moves along a direction approaching the base 100, thereby reducing a distance between the floating support part 300 and the base 100, improving the automation capability of the floating support part 300, and further preventing the floating support part 300 from squeezing the display screen.

As described above, the display screen may be an integrated structure, and the electronic device includes screen support parts. A middle portion between two adjacent screen support parts in the display screen (that is, a portion corresponding to the hinge mechanism) also has a certain effect of being unfolded and supported under support and fixation of the display screen by the two adjacent screen support parts. Moreover, the floating support part 300 can also be used to provide some support for the middle portion of the display screen. Certainly, to further improve the support effect on the portion of the display screen corresponding to the hinge mechanism, optionally, the hinge mechanism disclosed in this embodiment of this application may further include a support plate 610. The first linkage member and the second linkage member are each connected to the support plate 610, and the first linkage member and the second linkage member are each configured to drive the corresponding support plate 610 to rotate relative to the base 100.

With the foregoing technical solution adopted, in the case that the hinge mechanism is in the first state, the corresponding support plates 610 of the first linkage member and second linkage member can support portions of corresponding regions of the display screen, so that a portion of the display screen corresponding to the hinge mechanism can be substantially supported by the support plates 610 and the floating support part 300, improving the entire support effect on the display screen, thereby improving the display effect and service life of the display screen.

Specifically, the first linkage member (and the second linkage member) may be fixedly connected to the corresponding support plate 610, so that the support plate 610 can provide reliable support for the display screen. In addition, the specific size and shape of the support plate 610 may be correspondingly determined based on parameters such as shapes and sizes of other components in the hinge mechanism. This is not limited herein.

As described above, in the case that the hinge mechanism is in the second state, the connecting parts 210 of the first linkage member and second linkage member are both located on the side of the base 100 facing the screen support side, that is, the hinge mechanism is applicable to an inward folded electronic device. When such electronic device is in a folded state, the hinge mechanism needs to be used for providing an accommodating space for a display screen, ensuring that the display screen is not squeezed by components moving relative to each other in the hinge mechanism.

In a case that the hinge mechanism disclosed in this embodiment of this application includes the support plate 610, to provide an avoidance space for the display screen, the first linkage member may be rotatably connected to the corresponding support plate 610, so that the two can rotate relative to each other. Certainly, since the first linkage member and the second linkage member are substantially symmetrical in structure, for a fitting relationship between the second linkage member and the corresponding support plate 610, reference may be made to the first linkage member.

In a case that the first linkage member and the support plate 610 can rotate relative to each other, to ensure that the support plate 610 can rotate relative to the first linkage member, the base 100 may be provided with a first hinging part 171, the first linkage member may be provided with a second hinging part 231, and the support plate 610 is provided with a third hinging part 620 and a fourth hinging part 630. In addition, the first hinging part 171 is rotatably connected to the third hinging part 620, and the second hinging part 231 is rotatably connected to the fourth hinging part 630. In this case, rotating axes of the first hinging part 171, the second hinging part 231, the second rotating part 220, and the like are designed, more specifically, the rotating axis of the third hinging part 620 may be located on a side of the rotating axis of the second rotating part 220 facing away from the second linkage member, so that during rotation of the first linkage member relative to the base 100 around the rotating axis of the second rotating part 220, the support plate 610 can rotate relative to the base 100 by taking the rotating axis of the second rotating part 220 as a virtual axis. In addition, with connection of the first hinging part 171 and the third hinging part 620, the first hinging part 171 can move in a rail of the third hinging part 620, achieving the purpose of allowing the support plate 610 to rotate relative to the first linkage member.

In a case that the linkage members and the support plates 610 can rotate relative to each other, when the hinge mechanism is in the first state, the support plates 610 all support the base 100, and first surfaces of the support plates 610 facing away from the base 100 are coplanar, so that the support plate capable of rotating relative to the first linkage member (and the second linkage member) can support the base 100 to provide reliable support for a corresponding portion of the display screen.

Certainly, in the above state, there is a gap between each of ends of two adjacent support plates 610 close to each other and the corresponding first linkage member (and the second linkage member), so as to ensure that the first linkage member can rotate relative to the corresponding support plate 610 in a process of the hinge mechanism switching from the first state to the second state. This allows a relative rotation angle between the two adjacent support plates 610 to be larger than a relative rotation angle between the first linkage member and the second linkage member, thereby providing an avoidance space for the display screen by using an expansion effect of the support plate 610, and preventing the display screen from being squeezed and damaged by the support plate 610 when the display screen is being folded and in the folded state.

Correspondingly, in the case that the hinge mechanism is in the second state, the first linkage member and the second linkage member each supports the corresponding support plate 610, that is, the support plate 610 corresponding to the first linkage member is supported by the first linkage member, the support plate 610 corresponding to the second linkage member is supported by the second linkage member, and first surfaces of two opposite support plates 610 form a flared structure, with a flared opening facing the base 100.

Specifically, when the hinge mechanism is in the first state, the first surfaces of two adjacent support plates 610 for supporting the display screen are coplanar. With the relative rotation of the first linkage member and the second linkage member, the first linkage member and the corresponding support plate 610 can also rotate relative to each other, and the second linkage member and the corresponding support plate 610 rotate relative to each other, so that rotation angles of the two adjacent support plates 610 can exceed 90°, thereby allowing a distance between sides of the two adjacent support plates 610 close to the base 100 to be greater than a distance between sides of the two adjacent support plates 610 away from the base 100, and achieving the purposes of allowing the two support plates 610 to form the flared structure and allowing the flared opening to face the base 100.

With the foregoing technical solution adopted, the support plate 610 of the hinge mechanism switching to the second state can move along a direction leaving the display screen so as to provide avoidance for the display screen, so that the display screen is substantially not squeezed by the support plate 610 (or the entire hinge mechanism) when being folded and in the folded state.

More specifically, surfaces of sides of the first linkage member and second linkage member facing the support plate 610 are arranged as inclined surfaces, so that during actions of the hinge mechanism, the support plate 610 can rotate relative to the first linkage member by a preset angle and is supported by the first linkage member.

Based on the hinge mechanism disclosed in any one of the foregoing embodiments, this application further discloses an electronic device. The electronic device includes a display screen, screen support parts, and the hinge mechanism disclosed in any one of the foregoing embodiments, where the connecting parts 210 of the first linkage member and second linkage member are each connected to the screen support part, that is, at least two screen support parts are provided. Moreover, the display screen is located on the screen support side of the base 100 in the hinge mechanism, and the display screen is supported by the floating support part 300 and the screen support parts of the hinge mechanism. Specifically, portions of the display screen corresponding to the screen support parts are all supported by the screen support parts, and a portion of the display screen corresponding to the hinge mechanism is at least supported by the floating support part 300 of the hinge mechanism. In the electronic device formed using the hinge mechanism, in a case that the hinge mechanism is in a second state, the display screen is surrounded by the hinge mechanism and the screen support parts, so that the electronic device is formed as an inward folded electronic device. When such electronic device is in a folded state, the display screen can be protected by the screen support parts and the hinge mechanism, so that the display screen is not prone to friction or collision with external objects, which is conducive to prolonging the service life of the display screen.

It should be noted that the terms "include", "comprise", or any of their variants are intended to cover a non-exclusive inclusion, such that a process, method, article, or apparatus that includes a series of elements includes not only those elements but also other elements that are not expressly listed, or further includes elements inherent to such process, method, article, or apparatus. Without more constraints, an element preceded by "includes a..." does not preclude the presence of other identical elements in the process, method, article, or apparatus that includes the element. Furthermore, it should be noted that the scope of the method and apparatus in the embodiments of this application is not limited to functions being performed in the order shown or discussed, but may further include functions being performed at substantially the same time or in a reverse order, depending on the functions involved. For example, the described method may be performed in an order different from that described, and various steps may be added, omitted, or combined. In addition, features described with reference to some examples may be combined in other examples.

The foregoing describes the embodiments of this application with reference to the accompanying drawings. However, this application is not limited to the foregoing specific implementations. These specific implementations are merely illustrative rather than restrictive. Inspired by this application, persons of ordinary skill in the art may develop many other forms without departing from the protection scope of the claims.

## Claims

1. A hinge mechanism, wherein
the hinge mechanism comprises a base (100), a first rotating part (131), a linkage member (200), and a floating support part (300), wherein
the first rotating part (131) and the linkage member (200) are both provided in plurality, and the plurality of first rotating parts (131) are all disposed on the base (100); the linkage member (200) is an integral structural member, each linkage member (200) comprises a connecting part (210) and a second rotating part (220), a plurality of second rotating parts (220) are rotatably connected to the plurality of first rotating parts (131) in one-to-one correspondence, each connecting part (210) is configured to be fixedly connected to a screen support part of an electronic device, and the plurality of linkage members (200) comprise a first linkage member and a second linkage member; and the floating support part (300) is disposed on a side of the base (100) facing a screen support side, and the floating support part (300) and the base (100) are movably connected to each other along distribution directions of the two; and
the hinge mechanism has a first state and a second state, wherein in a case that the hinge mechanism is in the first state, the connecting part (210) of the first linkage member is located on one side of the base (100), and the connecting part (210) of the second linkage member is located on another side of the base (100), at least one of the plurality of second rotating parts (220) supports the floating support part (300), and a distance between an outer side wall of the base (100) facing away from a rotating axis of the first rotating part (131) and the floating support part (300) is a first distance; and
in a case that the hinge mechanism is in the second state, connecting parts (210) of the first linkage member and second linkage member are both located on the side of the base (100) facing the screen support side, the second rotating part (220) avoids the floating support part (300), a distance between the outer side wall of the base (100) and the floating support part (300) is a second distance, and the second distance is less than the first distance;
**characterised in that**
the hinge mechanism further comprises support plates (610), the first linkage member and the second linkage member are each connected to a support plate (610), and the first linkage member and the second linkage member are each configured to drive the corresponding support plate (610) to rotate relative to the base (100); wherein
the base (100) is provided with a first hinging part (171), the first linkage member is provided with a second hinging part (231), and the support plate (610) is provided with a third hinging part (620) and a fourth hinging part (630), wherein the first hinging part (171) is rotatably connected to the third hinging part (620), and the second hinging part (231) is rotatably connected to the fourth hinging part (630); and
in the case that the hinge mechanism is in the first state, first surfaces of the support plates (610) facing away from the linkage member (200) are coplanar, two opposite support plates (610) both support the base (100); and in the case that the hinge mechanism is in the second state, the linkage members (200) support the support plates (610), and the first surfaces of the two support plates (610) form a flared structure, with a flared opening facing the base (100).

2. The hinge mechanism according to claim 1, wherein the hinge mechanism further comprises a synchronization component, the synchronization component comprises a first synchronization swing arm (410) and a second synchronization swing arm (420), the first synchronization swing arm (410) and the second synchronization swing arm (420) are each rotatably connected to the base (100) through a connecting rod (720), and the first synchronization swing arm (410) is in transmission connection with the second synchronization swing arm (420); the first synchronization swing arm (410) is connected to the first linkage member, and the first linkage member is configured to drive the first synchronization swing arm (410) to rotate relative to the base (100); and the second synchronization swing arm (420) is connected to the second linkage member, and the second linkage member is configured to drive the second synchronization swing arm (420) to rotate relative to the base (100).

3. The hinge mechanism according to claim 2, wherein the first synchronization swing arm (410) and the second synchronization swing arm (420) are each provided with engaging teeth; the hinge mechanism further comprises a first gear (431) and a second gear (432) engaged with each other; and the first synchronization swing arm (410) is in transmission connection with the first gear (431), and the second synchronization swing arm (420) is in transmission connection with the second gear (432).

4. The hinge mechanism according to claim 2, wherein the hinge mechanism further comprises a first elastic member (510), and in a direction of the rotating axis of the first rotating part (131), the first elastic member (510) is connected between the base (100) and the first synchronization swing arm (410), and the first elastic member (510) is in a stretched or compressed state to squeeze the first synchronization swing arm (410) and a surface of the base (100) attached to the first synchronization swing arm (410).

5. The hinge mechanism according to claim 2, wherein the hinge mechanism further comprises a first elastic member (510), a limiting member (140), and a positioning member (150), wherein the positioning member (150) and the base (100) are apart from each other and fixedly disposed in a direction of the rotating axis, the limiting member (140) and the first synchronization swing arm (410) are both disposed between the base (100) and the positioning member (150), and the limiting member (140) is located between the first synchronization swing arm (410) and the positioning member (150);
an end of the limiting member (140) facing the first synchronization swing arm (410) is provided with a plurality of first limiting protrusions (161) spaced apart along a circumferential direction of the rotating axis, an end of the first synchronization swing arm (410) facing the limiting member (140) is provided with a plurality of second limiting protrusions (441) spaced apart along the circumferential direction of the rotating axis, and through the first limiting protrusions (161) and the second limiting protrusions (441), the limiting member (140) and the first synchronization swing arm (410) rotatably fit with each other in the circumferential direction of the rotating axis and movably fit with each other in the direction of the rotating axis; and
in the direction of the rotating axis of the first rotating part (131), the first elastic member (510) is connected to the limiting member (140) to squeeze the limiting member (140) and the first synchronization swing arm (410).

6. The hinge mechanism according to claim 1, wherein the hinge mechanism further comprises a second elastic member (520), the second elastic member (520) is connected between the floating support part (300) and the base (100), and in the case that the hinge mechanism is in the first state, the second elastic member (520) is in a stretched or compressed state to squeeze the floating support part (300) and the second rotating part (220).

7. The hinge mechanism according to claim 1, wherein the first rotating part (131) is provided with a recess, the second rotating part (220) is slidably disposed in the recess, an inner wall of the recess is provided with a guide rail (132), the second rotating part (220) is provided with a guide slot (221), the guide rail (132) slidably fit with the guide slot (221), and the guide rail (132) and the guide slot (221) fit with each other in a limiting manner in the direction of the rotating axis of the first rotating part (131).

8. An electronic device, **characterized by** comprising a display screen, screen support parts, and the hinge mechanism according to any one of claims 1 to 7, wherein the connecting parts (210) of the first linkage member and second linkage member are each connected to the screen support part, and the display screen is supported by the floating support part (300) of the hinge mechanism and the screen support parts.

## Patentansprüche

1. Ein Scharniermechanismus, wobei der Scharniermechanismus eine Basis (100), ein erstes Drehteil (131), ein Kopplungselement (200) und ein schwimmendes Stützteil (300) beinhaltet, wobei
das erste Drehteil (131) und das Kopplungselement (200) beide in einer Vielzahl bereitgestellt sind und die Vielzahl von ersten Drehteilen (131) alle auf der Basis (100) angeordnet sind; das Kopplungselement (200) ein einstückiges Strukturelement ist, jedes Kopplungselement (200) ein Verbindungsteil (210) und ein zweites Drehteil (220) beinhaltet, eine Vielzahl von zweiten Drehteilen (220) mit der Vielzahl von ersten Drehteilen (131) in einer Eins-zu-Eins-Entsprechung drehbar verbunden sind, jedes Verbindungsteil (210) konfiguriert ist, um mit einem Bildschirmstützteil einer elektronischen Vorrichtung fest verbunden zu sein, und die Vielzahl von Kopplungselementen (200) ein erstes Kopplungselement und ein zweites Kopplungselement beinhalten; und das schwimmende Stützteil (300) an einer Seite der Basis (100) angeordnet ist, die einer Bildschirmstützseite zugewandt ist, und das schwimmende Stützteil (300) und die Basis (100) entlang Verteilungsrichtungen der beiden beweglich miteinander verbunden sind; und
der Scharniermechanismus einen ersten Zustand und einen zweiten Zustand aufweist, wobei in einem Fall, in dem der Scharniermechanismus in dem ersten Zustand ist, das Verbindungsteil (210) des ersten Kopplungselements sich an einer Seite der Basis (100) befindet und das Verbindungsteil (210) des zweiten Kopplungselements sich an einer anderen Seite der Basis (100) befindet, mindestens eines der Vielzahl von zweiten Drehteilen (220) das schwimmende Stützteil (300) stützt und ein Abstand zwischen einer äußeren Seitenwand der Basis (100), die von einer Drehachse des ersten Drehteils (131) abgewandt ist, und dem schwimmenden Stützteil (300) ein erster Abstand ist; und
in einem Fall, in dem der Scharniermechanismus in dem zweiten Zustand ist, Verbindungsteile (210) des ersten Kopplungselements und des zweiten Kopplungselements sich beide an der Seite der Basis (100) befinden, die der Bildschirmstützseite zugewandt ist, das zweite Drehteil (220) dem schwimmenden Stützteil (300) ausweicht, ein Abstand zwischen der äußeren Seitenwand der Basis (100) und dem schwimmenden Stützteil (300) ein zweiter Abstand ist und der zweite Abstand kleiner als der erste Abstand ist;
**dadurch gekennzeichnet, dass**
der Scharniermechanismus ferner Stützplatten (610) beinhaltet, das erste Kopplungselement und das zweite Kopplungselement jeweils mit einer Stützplatte (610) verbunden sind und das erste Kopplungselement und das zweite Kopplungselement jeweils konfiguriert sind, um die entsprechende Stützplatte (610) anzutreiben, um sich relativ zu der Basis (100) zu drehen; wobei
die Basis (100) mit einem ersten scharnierenden Teil (171) versehen ist, das erste Kopplungselement mit einem zweiten scharnierenden Teil (231) versehen ist und die Stützplatte (610) mit einem dritten scharnierenden Teil (620) und einem vierten scharnierenden Teil (630) versehen ist, wobei das erste scharnierende Teil (171) mit dem dritten scharnierenden Teil (620) drehbar verbunden ist und das zweite scharnierende Teil (231) mit dem vierten scharnierenden Teil (630) drehbar verbunden ist; und
in dem Fall, in dem der Scharniermechanismus in dem ersten Zustand ist, erste Oberflächen der Stützplatten (610), die von dem Kopplungselement (200) abgewandt sind, koplanar sind, zwei gegenüberliegende Stützplatten (610) beide die Basis (100) stützen; und in dem Fall, in dem der Scharniermechanismus in dem zweiten Zustand ist, die Kopplungselemente (200) die Stützplatten (610) stützen und die ersten Oberflächen der zwei Stützplatten (610) eine aufgeweitete Struktur bilden, wobei eine aufgeweitete Öffnung der Basis (100) zugewandt ist.

2. Scharniermechanismus gemäß Anspruch 1, wobei der Scharniermechanismus ferner eine Synchronisationskomponente beinhaltet, die Synchronisationskomponente einen ersten Synchronisationsschwingarm (410) und einen zweiten Synchronisationsschwingarm (420) beinhaltet, der erste Synchronisationsschwingarm (410) und der zweite Synchronisationsschwingarm (420) jeweils durch eine Verbindungsstange (720) drehbar mit der Basis (100) verbunden sind und der erste Synchronisationsschwingarm (410) in Übertragungsverbindung mit dem zweiten Synchronisationsschwingarm (420) ist; der erste Synchronisationsschwingarm (410) mit dem ersten Kopplungselement verbunden ist und das erste Kopplungselement konfiguriert ist, um den ersten Synchronisationsschwingarm (410) anzutreiben, um sich relativ zu der Basis (100) zu drehen; und der zweite Synchronisationsschwingarm (420) mit dem zweiten Kopplungselement verbunden ist und das zweite Kopplungselement konfiguriert ist, um den zweiten Synchronisationsschwingarm (420) anzutreiben, um sich relativ zu der Basis (100) zu drehen.

3. Scharniermechanismus gemäß Anspruch 2, wobei der erste Synchronisationsschwingarm (410) und der zweite Synchronisationsschwingarm (420) jeweils mit Eingriffszähnen versehen sind; der Scharniermechanismus ferner ein erstes Zahnrad (431) und ein zweites Zahnrad (432) beinhaltet, die miteinander in Eingriff stehen; und der erste Synchronisationsschwingarm (410) in Übertragungsverbindung mit dem ersten Zahnrad (431) ist und der zweite Synchronisationsschwingarm (420) in Übertragungsverbindung mit dem zweiten Zahnrad (432) ist.

4. Scharniermechanismus gemäß Anspruch 2, wobei der Scharniermechanismus ferner ein erstes elastisches Element (510) beinhaltet und in einer Richtung der Drehachse des ersten Drehteils (131) das erste elastische Element (510) zwischen der Basis (100) und dem ersten Synchronisationsschwingarm (410) verbunden ist und das erste elastische Element (510) in einem gedehnten oder komprimierten Zustand ist, um den ersten Synchronisationsschwingarm (410) und eine an dem ersten Synchronisationsschwingarm (410) anliegende Oberfläche der Basis (100) zusammenzudrücken.

5. Scharniermechanismus gemäß Anspruch 2, wobei der Scharniermechanismus ferner ein erstes elastisches Element (510), ein Begrenzungselement (140) und ein Positionierungselement (150) beinhaltet, wobei das Positionierungselement (150) und die Basis (100) voneinander entfernt sind und in einer Richtung der Drehachse fest angeordnet sind, das Begrenzungselement (140) und der erste Synchronisationsschwingarm (410) beide zwischen der Basis (100) und dem Positionierungselement (150) angeordnet sind und das Begrenzungselement (140) sich zwischen dem ersten Synchronisationsschwingarm (410) und dem Positionierungselement (150) befindet;
ein Ende des Begrenzungselements (140), das dem ersten Synchronisationsschwingarm (410) zugewandt ist, mit einer Vielzahl von ersten Begrenzungsvorsprüngen (161) versehen ist, die entlang einer Umfangsrichtung der Drehachse beabstandet sind, ein Ende des ersten Synchronisationsschwingarms (410), das dem Begrenzungselement (140) zugewandt ist, mit einer Vielzahl von zweiten Begrenzungsvorsprüngen (441) versehen ist, die entlang der Umfangsrichtung der Drehachse beabstandet sind, und durch die ersten Begrenzungsvorsprünge (161) und die zweiten Begrenzungsvorsprünge (441) das Begrenzungselement (140) und der erste Synchronisationsschwingarm (410) in der Umfangsrichtung der Drehachse drehbar ineinanderpassen und in der Richtung der Drehachse beweglich ineinanderpassen; und
in der Richtung der Drehachse des ersten Drehteils (131) das erste elastische Element (510) mit dem Begrenzungselement (140) verbunden ist, um das Begrenzungselement (140) und den ersten Synchronisationsschwingarm (410) zusammenzudrücken.

6. Scharniermechanismus gemäß Anspruch 1, wobei der Scharniermechanismus ferner ein zweites elastisches Element (520) beinhaltet, das zweite elastische Element (520) zwischen dem schwimmenden Stützteil (300) und der Basis (100) verbunden ist und in dem Fall, in dem der Scharniermechanismus in dem ersten Zustand ist, das zweite elastische Element (520) in einem gedehnten oder komprimierten Zustand ist, um das schwimmende Stützteil (300) und das zweite Drehteil (220) zusammenzudrücken.

7. Scharniermechanismus gemäß Anspruch 1, wobei das erste Drehteil (131) mit einer Aussparung versehen ist, das zweite Drehteil (220) verschiebbar in der Aussparung angeordnet ist, eine Innenwand der Aussparung mit einer Führungsschiene (132) versehen ist, das zweite Drehteil (220) mit einem Führungsschlitz (221) versehen ist, die Führungsschiene (132) verschiebbar mit dem Führungsschlitz (221) zusammenpasst und die Führungsschiene (132) und der Führungsschlitz (221) in einer begrenzenden Weise in der Richtung der Drehachse des ersten Drehteils (131) ineinanderpassen.

8. Eine elektronische Vorrichtung, **dadurch gekennzeichnet, dass** sie einen Anzeigebildschirm, Bildschirmstützteile und den Scharniermechanismus gemäß einem der Ansprüche 1 bis 7 beinhaltet, wobei die Verbindungsteile (210) des ersten Kopplungselements und des zweiten Kopplungselements jeweils mit dem Bildschirmstützteil verbunden sind und der Anzeigebildschirm durch das schwimmende Stützteil (300) des Scharniermechanismus und die Bildschirmstützteile gestützt wird.

## Revendications

1. Un mécanisme de charnière, le mécanisme de charnière comprenant une base (100), une première pièce rotative (131), un organe de liaison (200), et une pièce de support flottant (300), dans lequel
la première pièce rotative (131) et l'organe de liaison (200) sont tous deux fournis en pluralité, et la pluralité de premières pièces rotatives (131) sont toutes disposées sur la base (100) ; l'organe de liaison (200) est un organe structural d'un seul tenant, chaque organe de liaison (200) comprend une pièce de raccordement (210) et une deuxième pièce rotative (220), une pluralité de deuxièmes pièces rotatives (220) sont raccordées de manière rotative à la pluralité de premières pièces rotatives (131) dans une correspondance biunivoque, chaque pièce de raccordement (210) est configurée pour être raccordée de manière fixe à une pièce de support d'écran d'un dispositif électronique, et la pluralité d'organes de liaison (200) comprend un premier organe de liaison et un deuxième organe de liaison ; et la pièce de support flottant (300) est disposée sur un côté de la base (100) faisant face à un côté de support d'écran, et la pièce de support flottant (300) et la base (100) sont raccordées de manière mobile l'une à l'autre le long de directions de distribution des deux ; et
le mécanisme de charnière ayant un premier état et un deuxième état, dans lequel dans un cas où le mécanisme de charnière est dans le premier état, la pièce de raccordement (210) du premier organe de liaison est située sur un côté de la base (100), et la pièce de raccordement (210) du deuxième organe de liaison est située sur un autre côté de la base (100), au moins une deuxième pièce rotative de la pluralité de deuxièmes pièces rotatives (220) supporte la pièce de support flottant (300), et une distance entre une paroi latérale externe de la base (100) orientée à l'opposé d'un axe de rotation de la première pièce rotative (131) et la pièce de support flottant (300) est une première distance ; et
dans un cas où le mécanisme de charnière est dans le deuxième état, des pièces de raccordement (210) du premier organe de liaison et du deuxième organe de liaison sont toutes deux situées sur le côté de la base (100) faisant face au côté de support d'écran, la deuxième pièce rotative (220) évite la pièce de support flottant (300), une distance entre la paroi latérale externe de la base (100) et la pièce de support flottant (300) est une deuxième distance, et la deuxième distance est inférieure à la première distance ; **caractérisé en ce que**
le mécanisme de charnière comprend en outre des plaques de support (610), le premier organe de liaison et le deuxième organe de liaison sont chacun raccordés à une plaque de support (610), et le premier organe de liaison et le deuxième organe de liaison sont chacun configurés pour entraîner la plaque de support (610) correspondante afin qu'elle tourne par rapport à la base (100) ; dans lequel la base (100) est pourvue d'une première pièce articulée (171), le premier organe de liaison est pourvu d'une deuxième pièce articulée (231), et la plaque de support (610) est pourvue d'une troisième pièce articulée (620) et d'une quatrième pièce articulée (630), dans lequel la première pièce articulée (171) est raccordée de manière rotative à la troisième pièce articulée (620), et la deuxième pièce articulée (231) est raccordée de manière rotative à la quatrième pièce articulée (630) ; et
dans le cas où le mécanisme de charnière est dans le premier état, de premières surfaces des plaques de support (610) orientées à l'opposé de l'organe de liaison (200) sont coplanaires, deux plaques de support (610) opposées supportent toutes deux la base (100) ; et dans le cas où le mécanisme de charnière est dans le deuxième état, les organes de liaison (200) supportent les plaques de support (610), et les premières surfaces des deux plaques de support (610) forment une structure évasée, avec une ouverture évasée faisant face à la base (100).

2. Le mécanisme de charnière selon la revendication 1, le mécanisme de charnière comprenant en outre un composant de synchronisation, le composant de synchronisation comprenant un premier bras pivotant de synchronisation (410) et un deuxième bras pivotant de synchronisation (420), le premier bras pivotant de synchronisation (410) et le deuxième bras pivotant de synchronisation (420) étant chacun raccordés de manière rotative à la base (100) par le biais d'une tige de raccordement (720), et le premier bras pivotant de synchronisation (410) étant en raccordement de transmission avec le deuxième bras pivotant de synchronisation (420) ; le premier bras pivotant de synchronisation (410) étant raccordé au premier organe de liaison, et le premier organe de liaison étant configuré pour entraîner le premier bras pivotant de synchronisation (410) afin qu'il tourne par rapport à la base (100) ; et le deuxième bras pivotant de synchronisation (420) étant raccordé au deuxième organe de liaison, et le deuxième organe de liaison étant configuré pour entraîner le deuxième bras pivotant de synchronisation (420) afin qu'il tourne par rapport à la base (100).

3. Le mécanisme de charnière selon la revendication 2, dans lequel le premier bras pivotant de synchronisation (410) et le deuxième bras pivotant de synchronisation (420) sont chacun pourvus de dents d'engrènement ; le mécanisme de charnière comprenant en outre un premier pignon (431) et un deuxième pignon (432) engrenés l'un à l'autre ; et le premier bras pivotant de synchronisation (410) étant en raccordement de transmission avec le premier pignon (431), et le deuxième bras pivotant de synchronisation (420) étant en raccordement de transmission avec le deuxième pignon (432).

4. Le mécanisme de charnière selon la revendication 2, le mécanisme de charnière comprenant en outre un premier organe élastique (510), et dans une direction de l'axe de rotation de la première pièce rotative (131), le premier organe élastique (510) étant raccordé entre la base (100) et le premier bras pivotant de synchronisation (410), et le premier organe élastique (510) étant dans un état étiré ou comprimé afin de compresser le premier bras pivotant de synchronisation (410) et une surface de la base (100) attachée au premier bras pivotant de synchronisation (410).

5. Le mécanisme de charnière selon la revendication 2, le mécanisme de charnière comprenant en outre un premier organe élastique (510), un organe de limitation (140), et un organe de positionnement (150), dans lequel l'organe de positionnement (150) et la base (100) sont séparés l'un de l'autre et disposés de manière fixe dans une direction de l'axe de rotation, l'organe de limitation (140) et le premier bras pivotant de synchronisation (410) sont tous deux disposés entre la base (100) et l'organe de positionnement (150), et l'organe de limitation (140) est situé entre le premier bras pivotant de synchronisation (410) et l'organe de positionnement (150) ;
une extrémité de l'organe de limitation (140) faisant face au premier bras pivotant de synchronisation (410) étant pourvue d'une pluralité de premières saillies de limitation (161) espacées le long d'une direction circonférentielle de l'axe de rotation, une extrémité du premier bras pivotant de synchronisation (410) faisant face à l'organe de limitation (140) étant pourvue d'une pluralité de deuxièmes saillies de limitation (441) espacées le long de la direction circonférentielle de l'axe de rotation, et par le biais des premières saillies de limitation (161) et des deuxièmes saillies de limitation (441), l'organe de limitation (140) et le premier bras pivotant de synchronisation (410) s'ajustant l'un à l'autre de manière rotative dans la direction circonférentielle de l'axe de rotation et s'ajustant l'un à l'autre de manière mobile dans la direction de l'axe de rotation ; et
dans la direction de l'axe de rotation de la première pièce rotative (131), le premier organe élastique (510) étant raccordé à l'organe de limitation (140) afin de compresser l'organe de limitation (140) et le premier bras pivotant de synchronisation (410).

6. Le mécanisme de charnière selon la revendication 1, le mécanisme de charnière comprenant en outre un deuxième organe élastique (520), le deuxième organe élastique (520) étant raccordé entre la pièce de support flottant (300) et la base (100), et dans le cas où le mécanisme de charnière est dans le premier état, le deuxième organe élastique (520) étant dans un état étiré ou comprimé afin de compresser la pièce de support flottant (300) et la deuxième pièce rotative (220).

7. Le mécanisme de charnière selon la revendication 1, dans lequel la première pièce rotative (131) est pourvue d'un évidement, la deuxième pièce rotative (220) est disposée de manière coulissante dans l'évidement, une paroi interne de l'évidement est pourvue d'un rail de guidage (132), la deuxième pièce rotative (220) est pourvue d'une fente de guidage (221), le rail de guidage (132) s'ajuste de manière coulissante à la fente de guidage (221), et le rail de guidage (132) et la fente de guidage (221) s'ajustent l'un à l'autre de manière limitative dans la direction de l'axe de rotation de la première pièce rotative (131).

8. Un dispositif électronique, **caractérisé en ce qu'**il comprend un écran d'affichage, des pièces de support d'écran, et le mécanisme de charnière selon l'une quelconque des revendications 1 à 7, dans lequel les pièces de raccordement (210) du premier organe de liaison et du deuxième organe de liaison sont chacune raccordées à la pièce de support d'écran, et l'écran d'affichage est supporté par la pièce de support flottant (300) du mécanisme de charnière et les pièces de support d'écran.
